# EUROPÄISCHE PATENTSCHRIFT

(11) **EP 2 617 272 B1**
(45) Veröffentlichungstag und Bekanntmachung des Hinweises auf die Patenterteilung: **02.03.2016**
(21) Anmeldenummer: 11763830.4
(22) Anmeldetag: 14.09.2011
(51) Int. Cl.: H05K 3/36, H05K 3/46, H05K 1/02

(54) **VERFAHREN ZUM HERSTELLEN EINER AUS MEHREREN LEITERPLATTENBEREICHEN BESTEHENDEN LEITERPLATTE SOWIE LEITERPLATTE**
METHOD FOR PRODUCING A CIRCUIT BOARD CONSISTING OF A PLURALITY OF CIRCUIT BOARD AREAS AND CIRCUIT BOARD
PROCÉDÉ DE FABRICATION D'UNE CARTE DE CIRCUITS IMPRIMÉS CONSTITUÉE DE PLUSIEURS ZONES DE CARTE DE CIRCUITS IMPRIMÉS, AINSI QUE CARTE DE CIRCUITS IMPRIMÉS

(30) Priorität: 17.09.2010 AT 5852010
(43) Veröffentlichungstag der Anmeldung: 24.07.2013
(73) Patentinhaber: AT & S Austria Technologie & Systemtechnik Aktiengesellschaft, 8700 Leoben-Hinterberg (AT)
(72) Erfinder: HASLEBNER, Nikolai, A-8045 Graz (AT); LEITGEB, Markus, A-8793 Trofaiach (AT); GÖSSLER, Michael, A-8720 Kobenz (AT); MORIANZ, Mike, A-8045 Graz (AT)
(74) Vertreter: Miksovsky, Alexander
(86) Internationale Anmeldenummer: PCT/AT2011/000374
(87) Internationale Veröffentlichungsnummer: WO 2012/034152

(56) Entgegenhaltungen:
- AT-U1- 10 029
- JP-A- 61 136 710
- US-A1- 2009 199 399
- US-B1- 6 237 218

## Beschreibung

Die vorliegende Erfindung bezieht sich auf ein Verfahren zum Herstellen einer aus mehreren Leiterplattenbereichen bestehenden Leiterplatte, wobei die einzelnen Leiterplattenbereiche aus wenigstens einer Lage aus einem insbesondere isolierenden Basismaterial und einem auf bzw. In dem Basismaterial befindlichen leitenden bzw. leitfähigen Muster ausgebildet werden, umfassend die folgenden Schritte:
- Bereitstellen eines Trägermaterials,
- Herstellen wenigstens einer Registrierungsmarkierung in dem Trägermaterial,
- Anordnen eines ersten Leiterplattenbereichs auf dem Trägermaterial unter Ausrichtung des ersten Leiterplattenbereichs relativ zu der Registrierungsmarkierung, und
- Verbinden des leitenden bzw. leitfähigen Musters des ersten Leiterplattenbereichs mit dem leitenden bzw. leitfähigen Muster wenigstens eines weiteren Leiterplattenbereichs.

Die vorliegende Erfindung bezieht sich darüber hinaus auf eine Leiterplatte, bestehend aus mehreren Leiterplattenbereichen, wobei die einzelnen Leiterplattenbereiche aus wenigstens einer Lage aus einem insbesondere isolierenden Basismaterial und einem auf bzw. in dem Basismaterial befindlichen leitenden bzw. leitfähigen Muster ausgebildet sind, umfassend:
- ein Trägermaterial,
- wenigstens eine in dem Trägermaterial ausgebildete Registrierungsmarkierung,
- einen auf dem Trägermaterial angeordneten ersten Leiterplattenbereich unter Ausrichtung dieses ersten Leiterplattenbereichs relativ zu der Registrierungsmarkierung, und
- eine Mehrzahl von Verbindungen der leitenden bzw. leitfähigen Muster des ersten Leiterplattenbereichs mit dem leitenden bzw. leitfähigen Muster wenigstens eines weiteren Leiterplattenbereichs.

Im Zusammenhang mit der Herstellung von Leiterplatten, welche aus mehreren, insbesondere getrennt hergestellten und vorbereiteten Leiterplattenbereichen bestehen, wie beispielsweise bzw. insbesondere bei der Herstellung einer starrflexiblen Leiterplatte, wird gemäß derzeit bekannten Verfahren derart vorgegangen, dass auf einem Trägermaterial ein Leiterplattenbereich angeordnet wird, worauf daran anschließende bzw. angrenzende Leiterplattenbereiche ebenfalls auf dem Trägermaterial angeordnet werden und üblicherweise miteinander kontaktiert werden. Darüber hinaus werden üblicherweise zusätzliche Lagen bzw. Ebenen einer derartigen Leiterplatte mit den voneinander getrennten bzw. getrennt hergestellten Leiterplattenbereichen verbunden, um insgesamt eine mehrlagige Leiterplatte herzustellen. Problematisch bei den derzeit bekannten Verfahren zum Herstellen derartiger Leiterplatten, welche aus mehreren Leiterplatten bzw. -bereichen bestehen, ist Insbesondere die Tatsache, dass eine Registrierung einzelner, miteinander zu verbindender bzw. zu kombinierender Leiterplattenbereiche nicht sinnvoll vorgenommen werden kann, so dass entsprechend den Toleranzen bei der Herstellung einzelner Leiterplattenbereiche entsprechende Unsicherheiten In der relativen Lage bzw. Positionierung derartiger, einzelner Leiterplattenbereiche existieren bzw. entstehen, welche miteinander bei der Herstellung einher Leiterplatte verbunden werden. Für die Ausrichtung eines Leiterplattenbereichs relativ zu einer Trägerschicht entsprechend dem Verfahren und der Leiterplatte der eingangs genannten Art kann beispielsweise auf die US-A 4626462 verwiesen werden.

Ein Verfahren und eine Leiterplatte der eingangs genannten Art sind beispielsweise der US 6,237,218 B1 (vergl, den Oberbegriff des Anspruchs 1 und des Anspruchs 8) entnehmbar, wobei auf unterschiedlichen Seiten eines Cores Leiterplattenbereiche angeordnet werden, wobei auf die Herstellung mehrlagiger Leiterplatten abgezielt wird.

Aus der US 2009/0199399 A1 ist ein Verfahren zur Herstellung von Leiterplatten mit eingebauten elektronischen Bauteilen zu entnehmen, wobei auf eine elektrische Ankopplung der zu integrierenden Bauteile abgezielt wird.

Weiters ist aus der AT 10 029 U1 ein Verfahren zur Herstellung einer starr-flexiblen Leiterplatte bekannt, gemäß welchem donnere Schichten aus isolierendem Material zum Einsatz gelangen können.

Derartige Ungenauigkeiten bei der gegenseitigen Anordnung einzelner, insbesondere zusätzlicher bzw. weiterer Leiterplattenbereiche führen unmittelbar zu Problemen bei einer weiteren Bearbeitung, beispielsweise bei einer Kontaktierung und/oder Verbindung derartiger einzelner Leiterplattenbereiche, so dass beispielsweise zur Sicherstellung einer entsprechenden Kontaktierung entsprechend große bzw. vergrößerte Verbindungestellen bzw. Kontakte zur Verfügung gestellt werden müssen, wobei dies eine gewünschte Miniaturisierung derartiger Leiterplatten bzw. Leiterplattenbereiche erschwert bzw. unmöglicht macht.

Die vorliegende Erfindung zielt daher darauf ab, die oben genannten Probleme zu vermeiden und ein Verfahren zum Herstellen einer aus mehreren Leiterplattenbereichen bestehenden Leiterplatte sowie eine Leiterplatte der eingangs genannten Art dahingehend zu verbessern, dass eine gegenseitige Ausrichtung bzw. Registrierung einzelner, insbesondere zusätzlicher miteinander zu koppelnder bzw. zu verbindender Leiterplattenbereiche verbessert wird, so dass nachfolgend insbesondere die Genauigkeit der Anordnung bei einer weiteren Verarbeitung einer derartigen, aus mehreren Teilbereichen bestehenden Leiterplatte verbessert werden kann.

Zur Lösung der oben genannten Aufgaben umfasst ein Verfahren der eingangs genannten Art im Wesentlichen den folgenden zusätzlichen Schritt:
- Anordnen des wenigstens einen weiteren Leiterplattenbereichs auf der gleichen bzw. gemeinsamen Oberfläche des Trägermaterials unter Ausrichtung relativ zu der Registrierungsmarkierung angrenzend an den ersten Leiterplattenbereich bzw. diesen wenigstens teilweise überlappend.

Da In dem Trägermaterial wenigstens eine Registrierungsmarkierung ausgebildet und der erste Leiterplattenbereich unter Ausrichtung dieses Leiterplattenbereichs relativ zu der Registrierungsmarkierung angeordnet wird, so dass erfindungsgemäß auch die daran angrenzenden bzw. diesen Leiterplattenbereich wenigstens teilweise überlappenden Leiterplattenbereiche ebenfalls im Hinblick auf den exakt positionierten, ersten Leiterplattenbereich durch eine Ausrichtung relativ zu der Registrierungsmarkierung positioniert werden können, kann eine Verbesserung der Ausrichtgenauigkeit der einzelnen, insbesondere zusätzlichen Leiterplattenbereiche relativ zueinander erzielt werden. Durch eine derartige Bereitstellung einer derartig verbesserten Ausricht- bzw. Positioniergenauigkeit einzelner, miteinander zu verbindender und aneinander angrenzender bzw. einander teilweise überlappender Leiterplattenbereiche wird es in weiterer Folge möglich, weitere vorzunehmende Bearbeitungsschritte, wie beispielsweise die Ausbildung von Verbindungs- bzw. Kontaktstellen oder dgl. an den Leiterplattenbereichen mit ebenfalls entsprechend erhöhter Präzision auszuführen, so dass insgesamt insbesondere Im Hinblick auf eine zunehmend gewünschte Miniaturisierung derartiger Elemente unter Berücksichtigung der erhöhten Auericht- bzw. Positioniergenauigkeit beispielsweise mit kleineren Verbindungselementen das Auslangen gefunden werden kann. Durch Vorsehen wenigstens einer Registrierungsmarkierung in dem Trägermaterial und nach einer Positionierung des ersten Leiterplattenbereichs auch der weiteren Leiterplattenbereiche relativ zu dieser wenigstens einen Registrierungsmarkierung lässt sich somit eine Leiterplatte herstellen, deren einzelne Leiterplattenbereiche mit erhöhter Ausricht- bzw. Positioniergenauigkeit angeordnet und in weiterer Folge miteinander gekoppelt bzw. verbunden werden können.

Für eine ordnungsgemäße und genaue Positionierung zumindest des ersten Leiterplattenbereiche wird gemäß einer bevorzugten Ausführungsform vorgeschlagen, dass wenigstens der erste Leiterplattenbereich auf dem Trägermaterial unter Zwischenschaltung eines Klebers festgelegt wird. Durch Einsatz eines Klebers gelingt eine unmittelbare Festlegung des ersten Leiterplattenbereichs auf dem Trägermaterial, so dass auch für die weiteren Leiterplattenbereiche, welche entsprechend dem unter Bezugnahme auf die Registrierungsmarkierung ausgerichteten ersten Leiterplattenbereich somit ebenfalls entsprechend genau bzw. genauer positioniert werden können, eine Verbesserung der jeweiligen Ausrichtung bzw. Anordnung erzielbar ist. Darüber hinaus kann durch Einsatz eines Klebers zur Festlegung des ersten Leiterplattenbereichs für die weiteren Leiterplattenbereiche mit kostengünstigeren Materialien, beispielsweise üblicherweise eingesetzten Prepregs mit gegebenenfalls großem bzw. erhöhtem Harzfluse das Auslangen gefunden werden, da bei weiteren Verarbeitungs- bzw. Bearbeitungsschritten der Leiterplatte unter gegebenenfalls erhöhtem Druck und/oder erhöhter Temperatur ein übermäßiges Fließen insbesondere der Basismeterialien der weiteren Leiterplattenbereiche durch Vorsehen des Klebers zur Festlegung des ersten Leiterplattenbereichs verhindert werden kann. Es kann somit beispielsweise auf die Verwendung von Low Flow Prepegs insbesondere für die weiteren Leiterplattenbereiche bzw. deren Basismaterialien verzichtet werden, so dass neben der erfindungsgemäß möglichen, verbesserten Registrierungs- bzw. Ausrichtgenauigkeit der einzelnen, miteinander zu koppelnden Leiterplattenbereiche auch eine kostengünstigere Herstellung erzielbar ist.

Im Zusammenhang mit dem weiteren Aufbau einer erfindungsgemäßen Leiterplatte unter Einsatz des erfindungsgemäßen Verfahrens wird gemäß einer weiters bevorzugten Ausführungsform vorgeschlagen, dass auf dem Trägermaterial und/oder eingebettet in den wenigstens einen weiteren Leiterplattenbereich zusätzlich wenigstens eine insbesondere elektronische Komponente angeordnet und mit wenigstens einem leitenden bis leitfähigen Muster kontaktiert wird, wobei die Komponente zu der wenigstens einen Registrierungsmarkierung ausgerichtet wird. Es wird somit durch Vorsehen der wenigstens einen Registrierungsmarkierung möglich, zusätzliche Komponenten ebenfalls entsprechend und relativ zu den einzelnen Leiterplattenbereichen genau zu positionieren, so dass auch für derartige zusätzliche, insbesondere elektronische Komponenten, welche üblicherweise über eine Vielzahl von vergleichsweise geringe Abmessungen aufweisenden Kontaktstellen verfügen, die für eine ordnungsgemäße Kontaktierung erforderliche Registrierungs- bzw. Positioniergenauigkeit zur Verfügung gestellt werden kann.

Insbesondere zur weiteren Vereinfachung der erfindungsgemäß vorgesehenen Verbindung des leitenden bzw. leitfähigen Musters der einzelnen Leiterplattenbereiche miteinander wird gemäß einer weiters bevorzugten Ausführungsform vorgeschlagen, dass das Trägermaterial von einer leitenden Folie gebildet wird. Durch Vorsehen einer leitenden Folie als Trägermaterial kann nach einer Festlegung bzw. Anordnung der einzelnen Leiterplattenbereiche auf dem Trägermaterial beispielsweise durch eine einfache Strukturierung des Trägermaterials und Vorsehen von entsprechenden Kontaktierungsstellen unmittelbar eine Kopplung bzw. Verbindung der leitenden bzw. leitfähigen Muster der einzelnen benachbart zueinander angeordneten Leiterplattenbereiche erfolgen.

Wie bereits mehrfach erwähnt, wird gemäß dem erfindungsgemäßen Verfahren ein weiterer Aufbau von zusätzlichen Lagen bzw. Schichten einer Insbesondere mehrlagigen Leiterplatte möglich, wobei in diesem Zusammenhang vorgeschlagen wird, dass auf den insbesondere nach einem Verbinden bzw. Verpressen eine im Wesentlichen gleiche Höhe aufweisenden und auf dem Trägermaterial angeordneten Leiterplattenbereichen zusätzliche Schichten bzw. Lagen einer mehrlagigen Leiterplatte angeordnet werden, wie dies einer weiters bevorzugten Ausführungsform des erfindungsgemäßen Verfahrens entspricht.

Insbesondere bei der Herstellung von starr-flexiblen Leiterplatten Ist die relative Positionierung der einzelnen Leiterplattenbereiche sowie deren Kontaktierung von wesentlicher Bedeutung, so dass unter Berücksichtigung der erfindungsgemaß erzielbaren, verbesserten Registrier- bzw. Positioniergenauigkeit gemäß einer weiters bevorzugten Ausführungsform vorgeschlagen wird, dass der erste Leiterplattenbereich von einem flexiblen Leiterplattenbereich gebildet wird und dass der wenigstens eine weitere Leiterplattenbereich von einem im Wesentlichen starren Leiterplattenbereich gebildet wird.

Insbesondere bei Herstellung einer starr-flexiblen Leiterplatte, wie dies oben angeführt wird, wird zumindest im Bereich des flexiblen Leiterplattenbereichs üblicherweise ein Aufbau weiterer Schichten bzw. Lagen zur Bereitstellung der gewünschten Flexibilität des Leiterplattenbereichs vermieden, so dass gemäß einer weiters bevorzugten Ausführungsform der vorliegenden Erfindung vorgeschlagen wird, dass nach einem Verbinden der leitenden Muster der einzelnen Leiterplattenbereiche das Trägermaterial wenigstens teilweise im Bereich des ersten Leiterplattenbereichs entfernt wird. Derart kann selbst bei Herstellung einer starr-flexiblen Leiterplatte beispielsweise ein entsprechend starres und widerstandsfähiges Trägermaterial beim Aufbau bzw. der Verbindung der einzelnen Leiterplattenbereiche eingesetzt werden, worauf In weiterer Folge insbesondere zur Bereitstellung des flexiblen Teilbereiches das Trägermaterial wenigstens teilweise im Bereich des ersten flexiblen Leiterplattenbereichs entfernt wird.

Zur Lösung der eingangs genannten Aufgaben umfasst darüber hinaus eine Leiterplatte der oben genannten Art Im Wesentlichen zusätzlich:
- den wenigstens einen weiteren Leiterplattenbereich angeordnet auf der gleichen bzw. gemeinsamen Oberfläche des Trägermaterials unter Ausrichtung relativ zu der Registrierungsmarkierung angrenzend an den ersten Leiterplattenbereich bzw. diesen wenigstens teilweise überlappend.

Wie bereits oben erwähnt, gelingt somit durch die erfindungsgemäß vorgesehene, wenigstens eine Registrierungsmarkierung in dem Trägermaterial eine verbesserte Ausricht- bzw. Positioniergenaulgkeit der einzelnen bzw. sämtlicher aneinander angrenzender bzw. einander teilweise überlappender Leiterplattenbereiche zueinander, so dass insbesondere in weiterer Folge vorzunehmende Ver- bzw. Bearbeitungsschritte ebenfalls mit erhöhter Genauigkeit und beispielsweise unter Ausbildung von weiteren Elementen der Leiterplatte mit verringerten Abmessungen möglich werden.

Zur Erzielung einer ordnungsgemäßen und sicheren Festlegung zumindest des ersten Leiterplattenbereichs wird gemäß einer bevorzugten Ausführungsform vorgeschlagen, dass wenigstens der erste Leiterplattenbereich auf dem Trägermaterial unter Zwischenschaltung eines Klebers festiegbar ist. Durch Verwendung eines Klebers zur Anordnung bzw. Festlegung des ersten Leiterplattenbereichs wird es darüber hinaus möglich, insbesondere für die Basismaterlallen der weiteren, daran anschließenden bzw. den ersten Leiterplattenbereich wenigstens teilweise überlappenden bzw. übergreifenden Leiterplattenbereiche mit Materialien geringerer Kosten das Auslangen zu finden.

Unter Berücksichtigung der durch die wenigstens eine Registrierungsmarkierung erzielbaren, erhöhten Positionier- bzw. Registriergenauigkeit zumindest des ersten Leiterplattenbereichs sowie der daran anschließenden bzw. angrenzenden Leiterplattenbereiche wird insbesondere im Zusammenhang mit einer weiteren Herstellung bzw. Anordnung von Elementen auf der erfindungsgefäßen Leiterplatte vorgeschlagen, dass auf dem Trägermaterial und/oder eingebettet in den wenigstens einen weiteren Leiterplattenbereich zusätzlich wenigstens eine insbesondere elektronische Komponente anordenbar und mit wenigstens einem leitenden bzw. leitfähigen Muster kontaktierbar ist, wobei die Komponente zu der wenigstens einen Registrierungsmarkierung ausrichtbar ist, wie dies einer weiters bevorzugten Ausführungsform der erfindungsgemäßen Leiterplatte entspricht. Derart können ohne zusätzliche Registrierungsmarkierungen auch elektronische Komponenten, welche üblicherweise eine Vielzahl von vergleichsweise geringe Abmessungen aufweisenden Verbindungs- bzw. Kontaktstellen aufweisen, entsprechend genau positioniert und angeordnet und nachfolgend kontaktiert werden.

Für eine Vereinfachung der Kontaktierung bzw. Verbindung der leitenden bzw. leitfähigen Muster der einzelnen Leiterplattenbereiche wird gemäß einer weiters bevorzugten Ausführungsform vorgeschlagen, dass das Trägermaterial von einer leitenden Folie gebildet ist.

Zur Herstellung einer mehrlagigen Leiterplatte nach einer Anordnung bzw. Positionierung der einzelnen, voneinander getrennten Leiterplattenbereiche, wie dies oben ausgeführt wurde, wird gemäß einer weiters bevorzugten Ausführungsform vorgeschlagen, dass auf den insbesondere eine im Wesentlichen gleiche Höhe aufweisenden und auf dem Trägermaterial angeordneten Leiterplattenbereichen zusätzliche Schichten bzw. Lagen einer mehrlagigen Leiterplatte angeordnet bzw. anordenbar sind.

Zur einfachen Herstellung von Verbindungen bzw. Kontakten der einzelnen Leiterplattenbereiche wird darüber hinaus vorgeschlagen, dass die Verbindungen zwischen den leitenden bzw. leitfähigen Mustern der einzelnen Leiterplattenbereiche von mit leitendem Material gefüllten Durchtrittslöchern, Vias, gebildet sind, wie dies einer weiters bevorzugten Ausführungsform der erfindungsgemäßen Leiterplatte entspricht.

Gemäß einer weiters bevorzugten Ausführungsform wird darüber hinaus vorgeschlagen, dass der erste Leiterplattenbereich von einem flexiblen Leiterplattenbereich gebildet ist und dass der wenigstens eine weitere Leiterplattenbereich von einem starren Leiterplattenbereich gebildet ist.

Die Erfindung wird nachfolgend anhand von in der beiliegenden Zeichnung schematisch dargestellten Ausführungsbeispielen näher erläutert. In dieser zeigen:
Fig. 1 einen teilweisen Schnitt durch eine erste Ausführungsform einer erfindungsgemäßen Leiterplatte, welche gemäß dem erfindungsgemäßen Verfahren hergestellt wurde;
Fig. 2 in einer zu Fig. 1 ähnlichen Darstellung einen Teilschnitt durch eine abgewandelte Ausführungsform einer erfindungsgemäßen Leiterplatte; und
Fig. 3 wiederum in einer teilweisen Schnittdarstellung eine weitere, abgeänderte Ausführungsform einer erfindungsgemäßen Leiterplatte, welche gemäß dem erfindungsgemäßen Verfahren hergestellt wurde.

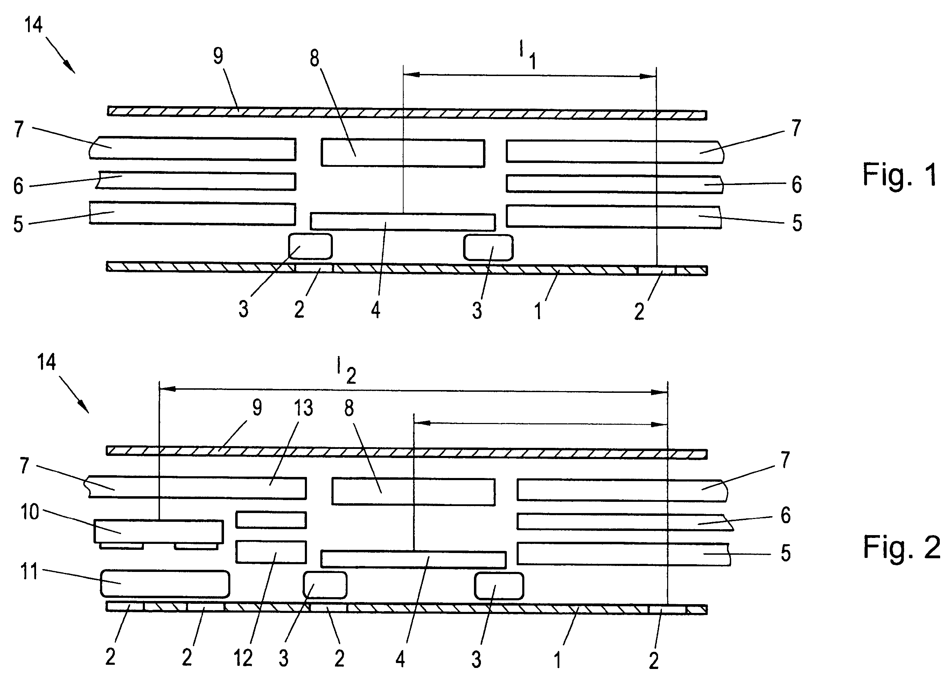

In Fig. 1 ist mit 1 ein Trägermaterial bezeichnet, welches mit einer Mehrzahl von mit 2 bezeichneten Registrierungsmarkierungen versehen ist.

Auf diesem Trägermaterial 1 erfolgt unter Zwischenschaltung von mit 3 bezeichneten Kleberstellen eine Anordnung bzw. Festlegung eines ersten Leiterplattenbereichs 4, wobei die Positionierung bzw. Registrierung des ersten Leiterplattenbereichs 4 relativ zur am rechten Rand der Darstellung gemäß Fig. 1 dargestellten Registrierungsmarkierung 2 durch einen Abstand I₁ bezeichnet ist. Der Abstand I₁ bezieht sich hierbei jeweils auf die mittlere Position sowohl der Registrierungsmarkierung 2 als auch des Leiterplattenbereichs 4.

Die Darstellung in Fig. 1 ist hierbei nicht maßstabsgetreu, da selbstverständlich die relativen Abmessungen der Registrierungsmarkierungen 2 um Größenordnungen kleiner als die Abmessungen des Leiterplattenbereichs 4 sind. Darüber hinaus ist davon auszugehen, dass die relativen Abmessungen der einzelnen Leiterplattenbereiche, insbesondere der Verhältnisse von Dicke zu Breite bzw. Länge nicht maßstabsgetreu sind.

Nach einer Anordnung bzw. Festlegung des Leiterplattenbereichs 4 auf dem Trägermaterial 1 erfolgt angrenzend bzw. anschließend an diesen Leiterplattenbereich 4 eine Anordnung von weiteren Leiterplattenbereichen 5 und 6, wobei ein Abstand zwischen diesen Leiterplattenbereichen 5 und 6 zu dem in Fig. 1 mittig angeordneten Leiterplattenbereich 4 zur Veranschaulichung vergrößert dargestellt ist.

Während der Leiterplattenbereich 4 beispielsweise von einem flexiblen Leiterplattenmaterial gebildet sein kann, sind beispielsweise die Leiterplattenbereiche 5 und 6 von entsprechend starren Leiterplattenbereichen gebildet, wobei diese beispielsweise von einem Prepreg gebildet sind, welches entsprechend vorgeschnitten ist.

Im Hinblick auf einen Aufbau weiterer Schichten bzw. Lagen der insgesamt mit 14 bezeichneten Leiterplatte erfolgt anschließend ein Vorsehen von weiteren Leiterplattenbereichen 7 als auch eines insbesondere in weiterer Folge entfernbaren Leiterplattenbereichs 8, welcher über dem flexiblen Bereich 4 angeordnet ist.

In der Darstellung gemäß Fig. 1 ist beispielsweise das Trägermaterial 1 von einer Folie aus einem leitenden bzw. leitfähigen Material, insbesondere Kupfer gebildet, wobei der in Fig. 1 dargestellte Teilbereich der Leiterplatte 14 in weiterer Folge durch ein Vorsehen einer Deckschicht 9 fertiggestellt wird, welche beispielsweise wiederum aus einem leitenden bzw. leitfähigen Material gebildet sein kann.

Während eines nachfolgenden Verpressens der einzelnen Schichten bzw. Lagen der Ausführungsform gemäß Fig. 1 verhindert die Anordnung von Klebestellen 3 zur Positionierung bzw. Festlegung des ersten Leiterplattenbereichs 4 insbesondere bei erhöhtem Druck und/oder erhöhter Temperatur ein Fließen der daran angrenzenden Leiterplattenbereiche 5 bzw. 6 bzw. des Basismaterials derselben, so dass die Leiterplattenbereiche, welche miteinander zu verbinden sind, entsprechend formstabil beibehalten bzw. angeordnet werden können.

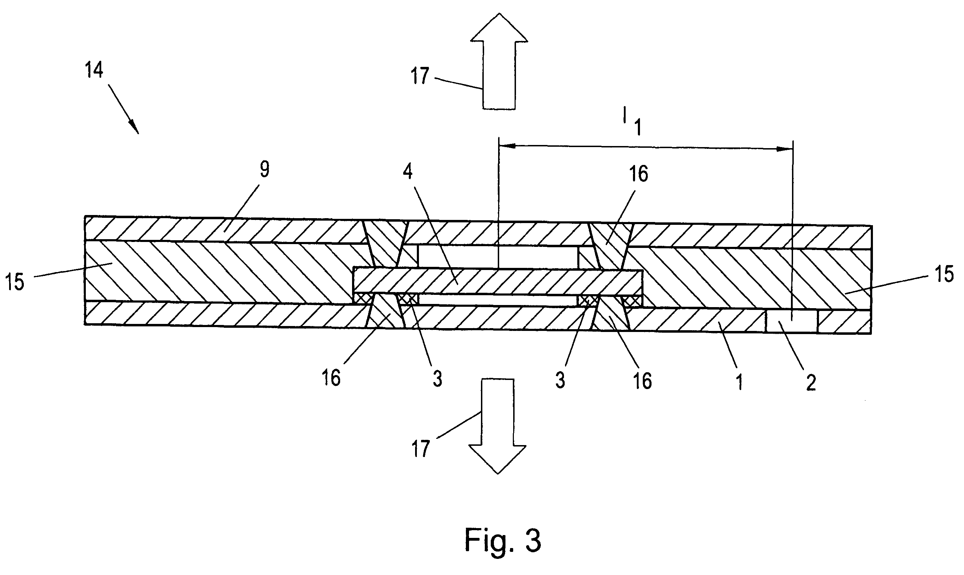

Darüber hinaus erfolgt, wie dies insbesondere aus Fig. 3 deutlich ersichtlich ist, eine Verbindung bzw. Kopplung der leitenden bzw. leitfähigen Muster der einzelnen Leiterplattenbereiche 4 bzw. 5, 6 und 7 miteinander, wobei derartige leitende bzw. leitfähige Muster, welche an bzw. in den einzelnen Leiterplattenbereichen vorgesehen sind, für sich gesehen bekannt sind und daher in der Zeichnung nicht näher dargestellt sind.

Eine derartige Verbindung kann hierbei auch durch eine entsprechende Strukturierung des im vorliegenden Fall von einer leitenden bzw. leitfähigen Folie gebildeten Trägermaterials 1 und/oder einer entsprechenden Strukturierung der Deckschicht 9 vorgenommen werden.

Durch Vorsehen wenigstens einer Registrierungsmarkierung 2 in dem Trägermaterial 1 und ein Positionieren des ersten Leiterplattenbereichs 4 sowie der daran angrenzenden bzw. anschließenden Leiterplattenbereiche 5, 6 relativ zu der Registrierungsmarkierung 2 kann somit eine erhöhte Ausricht- bzw. Positioniergenauigkeit der einzelnen Leiterplattenbereiche 4, 5, 6 und 7 relativ zueinander erhalten werden, so dass insbesondere die in weiterer Folge erforderlichen, herzustellenden Verbindungen mit entsprechend kleinen Abmessungen hergestellt werden können und somit zu einer Miniaturisierung des gesamten Aufbaus der Leiterplatte 14 beitragen können.

Bei Ausbildung des ersten Leiterplattenbereichs 4 als flexibler Leiterplattenbereich zur Herstellung einer starr-flexiblen Leiterplatte 14 erfolgt nach einer Fertigstellung des Verbunds der mehreren Schichten bzw. Lagen der Leiterplatte 14 eine Entfernung des entfernbaren Teilbereichs 8 als auch zumindest eine teilweise Entfernung des Trägermaterials 1 als auch der Deckschicht 9 im Bereich des flexiblen Leiterplattenbereichs 4, so dass der flexible Leiterplattenbereich 4 derart entsprechend freigelegt wird.

Bei der in Fig. 2 dargestellten Ausführungsform werden für gleiche bzw. ähnliche Elemente der Fig. 1 die gleichen Bezugszeichen beibehalten.

So ist auch bei der Ausführungsform gemäß Fig. 2 ein Trägermaterial 1 vorgesehen, welches mit einer Mehrzahl von Registrierungsmarkierungen 2 ausgebildet ist. Ähnlich wie bei der Ausführungsform gemäß Fig. 1 erfolgt über Klebestellen 3 eine Festlegung eines ersten Teilbereichs 4 der Leiterplatte, wobei auf der rechten Seite der Darstellung gemäß Fig. 2 ähnlich wie bei der Ausführungsform gemäß Fig. 1 wiederum Leiterplattenbereiche 5, 6 und 7 anschließen.

Darüber hinaus ist bei der Ausführungsform gemäß Fig. 2 vorgesehen, dass auf dem Trägermaterial 1 zusätzlich eine insbesondere elektronische Komponente 10 angeordnet bzw. in die Leiterplatte 14 integriert wird, wobei die Festlegung der Komponente 10 wiederum über eine schematisch mit 11 angedeutete Klebestelle erfolgt. Eine Kontaktierung der Komponente 10 mit wenigstens einem leitenden bzw. leitfähigen Muster erfolgt über an sich bekannte Verfahrensführungen, beispielsweise über ein Löten, mittels Mikrovias, etc.

Zwischen dem flexiblen Teilbereich 4 und der Komponente 10 sind entsprechend in ihren Abmessungen abgestimmte Leiterplattenbereiche 12 und 13 vorgesehen.

Ähnlich wie bei der Ausführungsform gemäß Fig. 1 erfolgt auch bei der Ausführungsform gemäß Fig. 2 eine Positionierung des Leiterplattenbereichs 4 relativ zu einer Registrierungsmarkierung 2 entsprechend dem wiederum mit I₁ bezeichneten Abstand der jeweils mittigen Positionen.

Darüber hinaus wird auch die Komponente 10 relativ zu der Registrierungsmarkierung 2 angeordnet, wobei ein Abstand I₂ angegeben ist.

Es ist unmittelbar einsichtig, dass somit durch Bereitstellung der Registrierungsmarkierung 2 in dem Trägermaterial 1 nicht nur eine entsprechend erhöhte Ausricht- bzw. Positioniergenauigkeit des ersten Leiterplattenbereichs 4 sowie der daran angrenzenden Leiterplattenbereiche 5, 6, 7 sowie 12 und 13 erzielbar ist, sondern auch eine entsprechend erhöhte Präzision der relativen Positionierung insbesondere für eine nicht näher dargestellte Kontaktierung zwischen den Leiterplattenbereichen 4, 5, 6 als auch der Komponente 10 erzielbar ist.

Ähnlich wie bei der Ausführungsform gemäß Fig. 1 erfolgt nach einem beispielsweise Verpressen einzelner in Fig. 1 und 2 getrennt dargestellter Schichten bzw. Lagen eine Verbindung bzw. Kopplung der wiederum nicht dargestellten, leitenden bzw. leitfähigen Muster der einzelnen Leiterplattenbereiche als auch der Komponente 10. Hiebei kann wiederum das Trägermaterial 1 als auch gegebenenfalls das Deckmaterial 9 von einer leitenden bzw. leitfähigen Folie gebildet sein.

Falls der Leiterplattenbereich 4 wiederum als flexibler Leiterplattenbereich ausgebildet ist, kann beispielsweise der Bereich 8 nach einem Verpressen und einem wenigstens teilweisen Entfernen der Deckschicht 9 als auch gegebenenfalls des Trägermaterials 1 die gewünschte Flexibilität der insgesamt starr-flexiblen Leiterplatte 14 zur Verfügung stellen.

Anstelle eines leitenden bzw. leitfähigen Materials kann insbesondere das Trägermaterial 1 auch von einem entsprechend starren und festen Basismaterial gebildet sein, welches zumindest im Bereich des flexiblen Teilbereichs 4 nach einer Fertigstellung der Leiterplatte 14 entfernt werden kann bzw. wird.

In Fig. 3 ist eine weitere abgewandelte Ausführungsform dargestellt, wobei auf einem wiederum mit 1 bezeichneten Trägermaterial, welches eine Registrierungsmarkierung 2 aufweist, unter Zwischenschaltung von Klebestellen 3 ein erster Leiterplattenbereich 4 festlegbar ist.

Ähnlich wie bei den vorangehenden Ausführungsformen erfolgt wiederum eine Ausrichtung bzw. Positionierung der zentralen bzw. mittigen Position des ersten Leiterplattenbereichs 4 relativ zu der Registrierungsmarkierung 2 entsprechend einem gewählten Abstand I₁.

Während bei den Ausführungsformen gemäß Fig. 1 und Fig. 2 an den Leiterplattenbereich 4 anschließende bzw. angrenzende Leiterplattenbereiche 5, 6 räumlich benachbart sind, ist bei der in Fig. 3 dargestellten Ausführungsform ersichtlich, dass Leiterplattenbereiche 15 den Leiterplattenbereich 4 wenigstens teilweise umschließen bzw. überlappen. Nach einem Anordnen bzw. Vorsehen einer wiederum mit 9 bezeichneten Deckschicht zur Kopplung bzw. Verbindung der leitenden bzw. leitfähigen Muster der einzelnen Leiterplattenbereiche 4 bzw. 15 werden Durchtrittsöffnungen, beispielsweise Laser, Mikrovias 16 hergestellt, welche durch ein Füllen mit einem leitenden bzw. leitfähigen Material eine Kopplung von leitenden Teilbereichen der Leiterplattenbereiche 4 und 15 ermöglichen. Derartige Mikrovias bzw. allgemein Durchtrittsöffnungen 16 zur Kopplung einzelner Leiterplattenlagen sind für sich gesehen bekannt.

Bei der in Fig. 3 dargestellten Ausführungsform sind beispielsweise sämtliche Leiterplattenbereiche 4 und 15 jeweils von starren Leiterplattenbereichen bzw. -elementen gebildet, so dass der zu integrierende Leiterplattenbereich 4 wiederum entsprechend genau relativ zu der Registrierungsmarkierung 2 positioniert werden kann.

Ein weiterer Aufbau von zusätzlichen Schichten bzw. Lagen der wiederum mit 14 bezeichneten Leiterplatte wird durch die Pfeile 17 angedeutet.

Insgesamt lässt sich somit durch einfache Bereitstellung wenigstens einer Registrierungsmarkierung 2 in einem Trägermaterial 1 bzw. einer Basis eine stark erhöhte Präzision bzw. Genauigkeit bei der Ausrichtung bzw. Positionierung von einzelnen Leiterplattenbereichen 4, 5, 6, 7 bzw. 15 relativ zueinander erzielen.

Derartige Leiterplattenbereiche 4, 5, 6, 7 bzw. 15 können neben einer starr-flexiblen Ausbildung einer Leiterplatte, wie sie in Fig. 1 und 2 angedeutet ist, beispielsweise auch aufgrund unterschiedlicher Strukturierung und insbesondere unterschiedlicher Integration von zusätzlichen Elementen getrennt hergestellt werden und in weiterer Folge durch Kopplung einzelner, getrennt hergestellter Leiterplattenbereiche zu einer vollständigen Leiterplattenstruktur 14 zusammengebaut werden.

Auch bei der in Fig. 3 dargestellten Ausführungsform kann ähnlich wie bei der in Fig. 2 dargestellten Ausführungsform zusätzlich durch Ausrichtung weiterer elektronischer Komponenten 10 relativ zu der Registrierungsmarkierung 2 auch eine erhöhte Genauigkeit einer relativen Positionierung zwischen derartigen zusätzlichen elektronischen Komponenten 10 und miteinander zu verbindenden bzw. koppelnden Leiterplattenbereichen 4 und 15 erzielt werden.

Neben einer unmittelbaren Anordnung bzw. Festlegung einer derartigen elektronischen Komponente 10 unmittelbar auf der Trägerschicht bzw. dem Trägermaterial 1, wie dies in Fig. 2 dargestellt ist, kann eine Anordnung bzw. Integration einer derartigen elektronischen Komponente 10 beispielsweise auch in einem an den mittleren bzw. zentralen Leiterplattenbereich 4 anschließenden bzw. angrenzenden Leiterplattenbereich 5 bzw. 6 oder 15 vorgenommen werden.

## Patentansprüche

1. Verfahren zum Herstellen einer aus mehreren Leiterplattenbereichen bestehenden Leiterplatte (14), wobei die einzelnen Leiterplattenbereiche aus wenigstens einer Lage aus einem insbesondere isolierenden Basismaterial und einem auf bzw. in dem Basismaterial befindlichen leitenden bzw. leitfähigen Muster ausgebildet werden, umfassend die folgenden Schritte:
- Bereitstellen eines Trägermaterials (1),
- Herstellen wenigstens einer Registrierungsmarkierung (2) in dem Trägermaterial (1),
- Anordnen eines ersten Leiterplattenbereichs (4) auf dem Trägermaterial (1) unter Ausrichtung des ersten Leiterplattenbereichs (4) relativ zu der Registrierungsmarkierung (2), und
- Verbinden des leitenden bzw. leitfähigen Musters des ersten Leiterplattenbereichs (4) mit dem leitenden bzw. leitfähigen Muster wenigstens eines weiteren Leiterplattenbereichs (5, 6, 7, 12, 13, 15),
**gekennzeichnet durch** den zusätzlichen Schritt:
- Anordnen des wenigstens einen weiteren Leiterplattenbereichs (5, 6, 7, 12, 13, 15) auf der gleichen bzw. gemeinsamen Oberfläche des Trägermaterials (1) unter Ausrichtung relativ zu der Registrierungsmarkierung (2) angrenzend an den ersten Leiterplattenbereich (4) bzw. diesen wenigstens teilweise überlappend.

2. Verfahren nach Anspruch 1, **dadurch gekennzeichnet, dass** wenigstens der erste Leiterplattenbereich (4) auf dem Trägermaterial (1) unter Zwischenschaltung eines Klebers (3) festgelegt wird.

3. Verfahren nach Anspruch 1 oder 2, **dadurch gekennzeichnet, dass** auf dem Trägermaterial (1) und/oder eingebettet in den wenigstens einen weiteren Leiterplattenbereich zusätzlich wenigstens eine insbesondere elektronische Komponente (10) angeordnet und mit wenigstens einem leitenden bzw. leitfähigen Muster kontaktiert wird, wobei die Komponente (10) zu der wenigstens einen Registrierungsmarkierung (2) ausgerichtet wird.

4. Verfahren nach einem der Ansprüche 1 bis 3, **dadurch gekennzeichnet, dass** das Trägermaterial (1) von einer leitenden Folie gebildet wird.

5. Verfahren nach einem der Ansprüche 1 bis 4, **dadurch gekennzeichnet, dass** auf den insbesondere nach einem Verbinden bzw. Verpressen eine im Wesentlichen gleiche Höhe aufweisenden und auf dem Trägermaterial (1) angeordneten Leiterplattenbereichen (4, 5, 6, 15) zusätzliche Schichten bzw. Lagen einer mehrlagigen Leiterplatte (14) angeordnet werden.

6. Verfahren nach einem der Ansprüche 1 bis 5, **dadurch gekennzeichnet, dass** der erste Leiterplattenbereich (4) von einem flexiblen Leiterplattenbereich gebildet wird und dass der wenigstens eine weitere Leiterplattenbereich (5, 6) von einem im Wesentlichen starren Leiterplattenbereich gebildet wird.

7. Verfahren nach einem der Ansprüche 1 bis 6, **dadurch gekennzeichnet, dass** nach einem Verbinden der leitenden Muster der einzelnen Leiterplattenbereiche (4, 5, 6, 7, 12, 13, 15) das Trägermaterial (1) wenigstens teilweise im Bereich des ersten Leiterplattenbereichs (4) entfernt wird.

8. Leiterplatte, bestehend aus mehreren Leiterplattenbereichen, wobei die einzelnen Leiterplattenbereiche aus wenigstens einer Lage aus einem insbesondere isolierenden Basismaterial und einem auf bzw. in dem Basismaterial befindlichen leitenden bzw. leitfähigen Muster ausgebildet sind, umfassend:
- ein Trägermaterial (1),
- wenigstens eine in dem Trägermaterial (1) ausgebildete Registrierungsmarkierung (2),
- einen auf dem Trägermaterial (1) angeordneten ersten Leiterplattenbereich (4) unter Ausrichtung dieses ersten Leiterplattenbereichs (4) relativ zu der Registrierungsmarkierung (2), und
- eine Mehrzahl von Verbindungen (16) der leitenden bzw. leitfähigen Muster des ersten Leiterplattenbereichs (4) mit dem leitenden bzw. leitfähigen Muster wenigstens eines weiteren Leiterplattenbereichs (5, 8, 7, 12, 13, 15),
**dadurch gekennzeichnet, dass** die Leiterplatte zusätzlich umfasst:
- den wenigstens einen weiteren Leiterplattenbereich (5, 6, 7, 12, 13, 15) angeordnet auf der gleichen bzw. gemeinsamen Oberfläche des Trägermaterials (1) unter Ausrichtung relativ zu der Registrierungsmarkierung (2) angrenzend an den ersten Leiterplattenbereich (4) bzw. diesen wenigstens teilweise überlappend.

9. Leiterplatte nach Anspruch 8, **dadurch gekennzeichnet, dass** wenigstens der erste Leiterplattenbereich (4) auf dem Trägermaterial (1) unter Zwischenschaltung eines Klebers (3) festlegbar ist.

10. Leiterplatte nach Anspruch 8 oder 9, **dadurch gekennzeichnet, dass** auf dem Trägermaterial (1) und/oder eingebettet In den wenigstens einen weiteren Leiterplattenbereich zusätzlich wenigstens eine insbesondere elektronische Komponente (10) anordenbar und mit wenigstens einem leitenden bzw. leitfähigen Muster kontaktierbar ist, wobei die Komponente (10) zu der wenigstens einen Registrierungsmarkierung (2) ausrichtbar ist.

11. Leiterplatte nach einem der Ansprüche 8 bis 10, **dadurch gekennzeichnet, dass** das Trägermaterial (1) von einer leitenden Folie gebildet ist.

12. Leiterplatte nach einem der Ansprüche 8 bis 11, **dadurch gekennzeichnet, dass** auf den insbesondere eine im Wesentlichen gleiche Höhe aufweisenden und auf dem Trägermaterial angeordneten Leiterplattenbereichen (4, 5, 6, 15) zusätzliche Schichten bzw. Lagen einer mehrlagigen Leiterplatte (14) angeordnet bzw. anordenbar sind.

13. Leiterplatte nach einem der Ansprüche 8 bis 12, **dadurch gekennzeichnet, dass** die Verbindungen zwischen den leitenden bzw. leitfähigen Mustern der einzelnen Leiterplattenbereiche (4, 15) von mit leitendem Material gefüllten Durchtrittslöchern, Vias (16) oder dgl. gebildet sind.

14. Leiterplatte nach einem der Ansprüche 8 bis 13, **dadurch gekennzeichnet, dass** der erste Leiterplattenberelch (4) von einem flexiblen Leiterplattenbereich gebildet ist und dass der wenigstens eine weitere Leiterplattenbereich (5, 6) von einem starren Leiterplattenbereich gebildet ist.

## Claims

1. A method for producing a circuit board (14) consisting of a plurality of circuit board areas, wherein the individual circuit board areas comprise at least one layer made of an in particular insulating base material and a conducting or conductive pattern located on or in the base material, said method comprising the steps of:
- providing a substrate material (1),
- forming at least one registration mark (2) in the substrate material (1),
- arranging a first circuit board area (4) on the substrate material (1) while orienting the first circuit board area (4) relative to the registration mark (2), and
- connecting the conducting or conductive pattern of the first circuit board area (4) to the conducting or conductive pattern of at least one further circuit board area (5, 6, 7, 12, 13, 15),
**characterized by** the following additional step:
- arranging the at least one additional circuit board area (5, 6, 7, 12, 13, 15) adjoining the first circuit board area (4), or at least partially overlapping the first circuit board area, on the same or common surface of the substrate material (1) while orienting the same relative to the registration mark (2).

2. A method according to claim 1, **characterized in that** at least the first circuit board area (4) is fixed to the substrate material (1) via an interposed adhesive (3).

3. A method according to claim 1 or 2, **characterized in that** at least one in particular electronic component (10) is additionally arranged on the substrate material (1), and/or embedded in the at last one further circuit board area, and contacted with at least one conducting or conductive pattern, wherein the component (10) is oriented relative to the at least one registration mark (2).

4. A method according to any one of claims 1 to 3, **characterized in that** the substrate material (1) is formed by a conducting film.

5. A method according to any one of claims 1 to 4, **characterized in that** additional layers or plies of a multilayer circuit board (14) are arranged on the circuit board areas (4, 5, 6, 15) disposed on the substrate material (1) and, in particular, having identical heights after connecting or pressing.

6. A method according to any one of claims 1 to 5, **characterized in that** the first circuit board area (4) is comprised of a flexible circuit board area, and that the at least one further circuit board area (5, 6) is comprised of a substantially rigid circuit board area.

7. A method according to any one of claims 1 to 6, **characterized in that**, after having connected the conducting patterns of the individual circuit board areas (4, 5, 6, 7, 12, 13, 15), the substrate material (1) is at least partially removed in the region of the first circuit board area (4).

8. A circuit board consisting of a plurality of circuit board areas, wherein the individual circuit board areas comprise at least one layer made of an in particular insulating base material and a conducting or conductive pattern located on or in the base material, comprising:
- a substrate material (1),
- at least one registration mark (2) formed in the substrate material (1),
- a first circuit board area (4) arranged on the substrate material (1), said first circuit board area (4) being oriented relative to the registration mark (2), and
- a plurality of connections (16) of the conducting or conductive patterns of the first circuit board area (4) to the conducting or conductive patterns of at least one additional circuit board area (5, 6, 7, 12, 13, 15),
**characterized in that** the circuit board additionally comprises:
- the at least one additional circuit board area (5, 6, 7, 12, 13, 15) being arranged on the same or common surface of the substrate material (1) adjoining, or at least partially overlapping, the first circuit board area (4) and oriented relative to the registration mark (2).

9. A circuit board according to claim 8, **characterized in that** at least the first circuit board area (4) is fixable to the substrate material (1) via an interposed adhesive (3).

10. A circuit board according to claim 8 or 9, **characterized in that** at least one in particular electronic component (10) is additionally arrangeable on the substrate material (1), and/or embedded in the at last one further circuit board area, and contactable with at least one conducting or conductive pattern, said component (10) being orientable relative to the at least one registration mark (2).

11. A circuit board according to any one of claims 8 to 10, **characterized in that** the substrate material (1) is formed by a conducting film.

12. A circuit board according to any one of claims 8 to 11, **characterized in that** additional layers or plies of a multilayer circuit board (14) are arranged or arrangeable on the circuit board areas (4, 5, 6, 15) disposed on the substrate material and, in particular, having substantially identical heights and.

13. A circuit board according to any one of claims 8 to 12, **characterized in that** the connections between the conducting or conductive patterns of the individual circuit board areas (4, 15) are formed by passage openings filled with conductive material, i.e. vias (16), or the like.

14. A circuit board according to any one of claims 8 to 13, **characterized in that** the first circuit board area (4) is comprised of a flexible circuit board area and the at least one further circuit board area (5, 6) is comprised of a rigid circuit board area.

## Revendications

1. Procédé de fabrication d'une carte de circuits imprimés (14) constituée de plusieurs zones de carte de circuits imprimés, les zones de carte de circuits imprimés individuelles étant formées d'au moins une couche en un matériau de base en particulier isolant et d'un motif conducteur ou conductible se trouvant sur ou dans le matériau de base, comprenant les étapes suivantes :
- fourniture d'un matériau de support (1),
- réalisation d'au moins un marquage de repérage (2) dans le matériau de support (1),
- disposition d'une première zone de carte de circuits imprimés (4) sur le matériau de support (1) par alignement de la première zone de carte de circuits imprimés (4) par rapport au marquage de repérage (2), et
- liaison du motif conducteur ou conductible de la première zone de carte de circuits imprimés (4) avec le motif conducteur ou conductible d'au moins une autre zone de carte de circuits imprimés (5, 6, 7, 12, 13, 15),
**caractérisé par** l'étape supplémentaire suivante :
- disposition de l'au moins une autre zone de carte de circuits imprimés (5, 6, 7, 12, 13, 15) sur la même surface ou sur une surface commune du matériau de support (1) par alignement par rapport au marquage de repérage (2) de manière contiguë à la première zone de carte de circuits imprimés (4) ou de manière à chevaucher au moins partiellement celle-ci.

2. Procédé selon la revendication 1, **caractérisé en ce qu'**au moins la première zone de carte de circuits imprimés (4) est fixée sur le matériau de support (1) par interposition d'une colle (3).

3. Procédé selon la revendication 1 ou 2, **caractérisé en ce qu'**au moins un composant (10) en particulier électronique est disposé en plus sur le matériau de support (1) et/ou de manière intégrée dans l'au moins une autre zone de carte de circuits imprimés et mis en contact avec au moins un motif conducteur ou conductible, le composant (10) étant aligné sur l'au moins un marquage de repérage (2).

4. Procédé selon l'une des revendications 1 à 3, **caractérisé en ce que** le matériau de support (1) est formé par une feuille conductrice.

5. Procédé selon l'une des revendications 1 à 4, **caractérisé en ce que** des strates ou couches supplémentaires d'une carte de circuits imprimés (14) multicouche sont disposées sur les zones de carte de circuits imprimés (4, 5, 6, 15) disposées sur le matériau de support (1) et présentant, en particulier après une liaison ou une compression, une hauteur sensiblement identique.

6. Procédé selon l'une des revendications 1 à 5, **caractérisé en ce que** la première zone de carte de circuits imprimés (4) est formée par une zone de carte de circuits imprimés flexible et **en ce que** l'au moins une autre zone de carte de circuits imprimés (5, 6) est formée par une zone de carte de circuits imprimés sensiblement rigide.

7. Procédé selon l'une des revendications 1 à 6, **caractérisé en ce que**, après une liaison des motifs conducteurs des zones de carte de circuits imprimés (4, 5, 6, 7, 12, 13, 15) individuelles, le matériau de support (1) est retiré au moins partiellement dans la zone de la première zone de carte de circuits imprimés (4).

8. Carte de circuits imprimés, constituée de plusieurs zones de carte de circuits imprimés, les zones de carte de circuits imprimés individuelles étant formées d'au moins une couche en un matériau de base en particulier isolant et d'un motif conducteur ou conductible se trouvant sur ou dans le matériau de base, comprenant :
- un matériau de support (1),
- au moins un marquage de repérage (2) formé dans le matériau de support (1),
- une première zone de carte de circuits imprimés (4) disposée sur le matériau de support (1) par alignement de cette première zone de carte de circuits imprimés (4) par rapport au marquage de repérage (2), et
- une pluralité de liaisons (16) des motifs conducteurs ou conductibles de la première zone de carte de circuits imprimés (4) avec le motif conducteur ou conductible d'au moins une autre zone de carte de circuits imprimés (5, 6, 7, 12, 13, 15),
**caractérisée en ce que** la carte de circuits imprimés comprend en outre :
- l'au moins une autre zone de carte de circuits imprimés (5, 6, 7, 12, 13, 15) disposée sur la même surface ou sur la surface commune du matériau de support (1) par alignement par rapport au marquage de repérage (2) de manière contiguë à la première zone de carte de circuits imprimés (4) ou de manière à chevaucher celle-ci au moins partiellement.

9. Carte de circuits imprimés selon la revendication 8, **caractérisée en ce qu'**au moins la première zone de carte de circuits imprimés (4) peut être fixée sur le matériau de support (1) par interposition d'une colle (3).

10. Carte de circuits imprimés selon la revendication 8 ou 9, **caractérisée en ce qu'**au moins un composant (10) en particulier électronique peut être disposé en plus sur le matériau de support (1) et/ou de manière intégrée dans l'au moins une autre zone de carte de circuits imprimés, et mis en contact avec au moins un motif conducteur ou conductible, le composant (10) pouvant être aligné sur l'au moins un marquage de repérage (2).

11. Carte de circuits imprimés selon l'une des revendications 8 à 10, **caractérisée en ce que** le matériau de support (1) est formé par une feuille conductrice.

12. Carte de circuits imprimés selon l'une des revendications 8 à 11, **caractérisée en ce que** des strates ou couches supplémentaires d'une carte de circuits imprimés (14) multicouche sont disposées ou peuvent être disposées sur les zones de carte de circuits imprimés (4, 5, 6, 15) disposées sur le matériau de support et présentant en particulier une hauteur sensiblement identique.

13. Carte de circuits imprimés selon l'une des revendications 8 à 12, **caractérisée en ce que** les liaisons entre les motifs conducteurs ou conductibles des zones de carte de circuits imprimés (4, 15) individuelles sont formées par des trous de passage, des vias (16) ou équivalents remplis d'un matériau conducteur.

14. Carte de circuits imprimés selon l'une des revendications 8 à 13, **caractérisée en ce que** la première zone de carte de circuits imprimés (4) est formée par une zone de carte de circuits imprimés flexible et **en ce que** l'au moins une autre zone de carte de circuits imprimés (5, 6) est formée par une zone de carte de circuits imprimés rigide.
